(19)

Europäisches
Patentamt
European
Patent Office
Office européen
des brevets

(11) **EP 4 703 960 A1**

(12) **EUROPEAN PATENT APPLICATION**

(43) Date of publication:
**04.03.2026 Bulletin 2026/10**

(21) Application number: **24197093.8**

(22) Date of filing: **28.08.2024**

(51) International Patent Classification (IPC):
**G06F 30/392** (2020.01)   **G02B 6/12** (2006.01)
**G06F 30/398** (2020.01)   **G02F 3/00** (2006.01)
**G06E 1/00** (2006.01)   **G06E 3/00** (2006.01)

(52) Cooperative Patent Classification (CPC):
**G06F 30/392; G02B 6/12; G02B 6/125; G06E 1/00;
G06E 3/00; G06F 30/398;** G02B 2006/12147

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority:  **27.08.2024  GB 202412507**

(71) Applicant: **QuiX Quantum BV
7521 AN Enschede (NL)**

(72) Inventors:
• **KANNAN, Narasimhan
7521 AN Enschede (NL)**

• **RENEMA, Jelmer Jan
7521 AN Enschede (NL)**
• **DEMILLE, Trevor
7521 AN Enschede (NL)**

(74) Representative: **CMS Cameron McKenna Nabarro
Olswang LLP
Cannon Place
78 Cannon Street
London EC4N 6AF (GB)**

Remarks:
A request for correction of the description has been filed pursuant to Rule 139 EPC. A decision on the request will be taken during the proceedings before the Examining Division (Guidelines for Examination in the EPO, A-V, 3.).

(54) **FINDING NEW PRACTICAL IMPLEMENTATIONS OF UNIVERSAL LINEAR OPTICAL MESHES**

(57)    A method of generating a revised layout for implementing a universal linear optical mesh is defined. The method comprises starting with a known layout of a universal optical mesh, wherein: the known layout of the universal linear optical mesh comprises: a plurality of waveguides; and a plurality of couplers distributed over a plurality of interaction stages, wherein each coupler couples two of the waveguides. The method further comprises generating the revised layout by: identifying in the known layout a first arrangement of three couplers across three consecutive waveguides and obtaining the revised layout by replacing the first arrangement of three couplers with a second arrangement of three couplers.

FIG. 4A

EP 4 703 960 A1

## Description

Background

A universal linear optical mesh is an arrangement of waveguides, couplers and, in some cases, phase shifters that can be used to implement any suitable sized unitary operations on input light signals by mapping the unitary operation to the components of the universal linear optical mesh. Such universal linear optical meshes can be used for quantum computing, optical networking and routing and other optical applications. However, there are only a couple of known designs/layouts for universal linear optical meshes such as the Reck triangular scheme. Such designs/layouts may not map well to existing optical hardware, particularly when manufacturing constraints mean not all components in the optical hardware are performing at the expected level. In addition, existing universal linear optical mesh layouts can have known disadvantages, for example in the Reck scheme light in a first waveguide passes through a least number of couplers while light in an nth waveguide passes through a maximum number of couplers causing an unequal loss and phase distribution of light in different waveguides. In addition, the Reck scheme has a relatively large optical path length as the overall path length is 2n. Thus, it would be useful to have a technique for generating new layouts for universal linear optical meshes that map better to optical hardware.

The embodiments described below are not limited to implementations which solve any or all of the disadvantages of known universal linear optical mesh layouts.

Summary

This Summary is provided to introduce a selection of concepts in a simplified form that are further described below in the Detailed Description. This Summary is not intended to identify key features or essential features of the claimed subject matter, nor is it intended to be used as an aid in determining the scope of the claimed subject matter.

A first aspect provides a method of generating a revised layout for implementing a universal linear optical mesh. The method comprises starting with a known layout of a universal optical mesh, wherein: the known layout of the universal linear optical mesh comprises an arrangement of: a plurality of waveguides; and a plurality of couplers distributed over a plurality of interaction stages, wherein each coupler couples two of the waveguides. The method further comprises either: generating the revised layout by: identifying in the known layout a first arrangement of three couplers across three consecutive waveguides numbered k, k+1 and k+2, wherein a first coupler and a third coupler of the three couplers couple waveguides k+1 and k+2, and a second coupler of the three couplers couples waveguides k and k+1, wherein the second coupler is positioned between the first coupler and the third coupler, and wherein no other couplers positioned between the first coupler and the third coupler couple waveguides k, k+1 or k+2 to another waveguide; and obtaining the revised layout by replacing the first arrangement of three couplers with a second arrangement of three couplers, wherein the second arrangement of three couplers comprises a first coupler and a third coupler that couple waveguides k and k+1 and a second coupler, positioned between the first coupler and the second coupler, that couples waveguides k+1 and k+2. Alternatively, the method further comprises generating the revised layout by: identifying in the known layout a first arrangement of three couplers across three consecutive waveguides numbered k, k+1 and k+2, wherein a first coupler and third coupler of the three couplers couple waveguides k and k+1 and a second coupler of the three couplers couples waveguides k+1 and k+2, wherein the second coupler is positioned between the first and third coupler, and wherein no other couplers positioned between the first coupler and the third coupler couple waveguides k+1 or k+2 to another waveguide; and obtaining the revised layout by replacing the first arrangement of three couplers with a second arrangement of three couplers, wherein the second arrangement of three couplers comprises a first coupler and a third coupler that couple waveguides k+1 and k+2 and a second coupler, positioned between the first coupler and the second coupler, that couples waveguides k and k+1. The above method provides a way of generating/identifying a candidate arrangement/layout for a universal linear optical mesh from a known arrangement/layout for a universal linear optical mesh. This provides increased options for implementing universal linear optical meshes that can then be used for quantum computing or other optical switching or routing operations.

In some examples the method further comprises either building optical hardware based on the revised layout; or mapping the revised layout onto existing optical hardware. The optical hardware comprises a physical layout of waveguides and couplers. In some examples, an optical hardware may exist and mapping the revised layout onto the optical hardware comprises choosing which couplers and waveguides of the optical hardware to actively use and which to have act as null, unitary or throughput elements based on the revised layout. In other examples, a new optical hardware may be formed by building a system of waveguides and couplers based on the revised layout. This allows the revised layout to be used practically as universal linear optical mesh.

In some examples, the known layout of the universal optical mesh is a Reck triangular mesh. This provides a suitable starting point for the method in that it provides an example of a known layout of a universal optical mesh that can be used to generate revised layouts.

In some examples, the method comprises replacing the first arrangement of three couplers with a second arrangement of three couplers, and the second arrangement of three couplers comprises a first coupler and a third coupler that couple waveguides k+1 and k+2 and a second coupler, positioned between the first coupler and the second coupler, that couples waveguides k and k+1. In these examples, the method may further comprise if at a specific interaction stage containing the first coupler of the first arrangement another coupler couples waveguides k-1 and k, then in the second arrangement positioning the first coupler in an interaction stage subsequent to an interaction stage containing the another coupler; and if at a specific interaction stage containing the third coupler of the first arrangement another coupler couplers waveguides k-1 and k, then in the second arrangement positioning the third coupler in an interaction stage preceding an interaction stage containing the another coupler. This ensures that when the second arrangement is used to replace the first arrangement, no couplers already in the layout impact the second arrangement by coupling to a waveguide within the second arrangement within the interaction stages making up the second arrangement. This ensures the replacement works correctly.

In other examples, the method comprises replacing the first arrangement of three couplers with a second arrangement of three couplers, and the second arrangement of three couplers comprises a first coupler and a third coupler that couple waveguides k and k+1 and a second coupler, positioned between the first coupler and the first coupler, that couples waveguides k+1 and k+2. In these examples, the method may further comprise if at a specific interaction stage containing the first coupler of the first arrangement another coupler couples waveguides k+2 and k+3, then in the second arrangement positioning the first coupler in an interaction stage subsequent to the interaction stage containing the another coupler; and if at a specific interaction stage containing the third coupler of the first arrangement another coupler couplers waveguides k+2 and k+3, then in the second arrangement positioning the third coupler in an interaction stage preceding the interaction stage containing the another coupler. This ensures that when the second arrangement is used to replace the first arrangement, no couplers already in the layout impact the second arrangement by coupling to a waveguide within the second arrangement within the interaction stages making up the second arrangement. This ensures the replacement works correctly.

In some examples, the method further comprises compressing the revised layout by if after the replacing the first arrangement of three couplers with the second arrangement of three couplers (a) a specific coupler couples waveguides I and I+1 and another coupler couples waveguides I+2 and I+3 at different interaction stages and (b) no other coupler couples to waveguides I, I+1, I+2 or I+3 at an interaction stage between the different interaction stages, then further revising the revised layout so that the specific coupler and the another coupler are within the same interaction stage. Once a revised layout has been generated, the layout can be compressed to take as few interaction stages as possible. This allows the universal linear optical mesh to be implemented using a lower optical depth.

In some examples, the method further comprising generating multiple potential revised layouts for implementing a universal linear optical mesh. This can be done by either generating the multiple potential revised layouts by iteratively: starting from a previous revised layout; identifying in the previous revised layout a first arrangement of three couplers across three consecutive waveguides numbered k, k+1 and k+2, wherein a first coupler and a third coupler of the three couplers couple waveguides k+1 and k+2, and a second coupler of the three couplers couples waveguides k and k+1, wherein the second coupler is positioned between the first coupler and the third coupler, and wherein no other couplers positioned between the first coupler and the third coupler couple waveguides k, k+1, or k+2 to another waveguide; and obtaining an updated revised layout by replacing the first arrangement of three couplers with a second arrangement of three couplers, wherein the second arrangement of three couplers comprises a first coupler and a third coupler that couple waveguides k and k+1 and a second coupler, positioned between the first coupler and the second coupler, that couples waveguides k+1 and k+2. Alternatively, this can be done by iteratively: starting from a previous revised layout; identifying in the previous revised layout a first arrangement of three couplers across three consecutive waveguides numbered k, k+1 and k+2, wherein a first coupler and third coupler of the three couplers couple waveguides k and k+1 and a second coupler of the three couplers couples waveguides k+1 and k+2, wherein the second coupler is positioned between the first and third coupler, and wherein no other couplers positioned between the first coupler and the third coupler couple waveguides k, k+1 or k+2 to another waveguide; and obtaining an updated revised layout by replacing the first arrangement of three couplers with a second arrangement of three couplers, wherein the second arrangement of three couplers comprises a first coupler and a third coupler that couple waveguides k+1 and k+2 and a second coupler, positioned between the first coupler and the second coupler, that couples waveguides k and k+1. Thus the method described above can be repeated to provide multiple options or revised layouts for a universal linear optical mesh. The multiple options for the revised layouts can be analysed and a most suitable option for implementing the universal linear optical mesh layout chosen to practically/physically implement the universal linear optical mesh. In some cases, iterations may repeat until the result is a second known layout for a universal linear optical mesh. In other cases, iterations may repeat until no more first arrangements of the form from the iteration can be found in the previous revised layout. In yet other cases, a fixed number of iterations may be performed to obtain a suitable number of potential revised layouts for further analysis. Alternatively, the number of iterations may be the same as the number of modes of waveguides.

In some examples, the method further comprises mapping each of the multiple potential revised layouts onto an optical hardware comprising a plurality of waveguides and a plurality of couplers, wherein each coupler of the plurality of couplers couples two waveguides from the plurality of waveguides. The optical hardware can comprise existing optical hardware. The mapping the potential revised layouts onto the optical hardware comprises mapping the arrangement of waveguides and couplers from each potential revised layout onto the actual waveguides and couplers of the optical hardware such that the optical hardware can be used to implement practically and physically the universal linear optical mesh.

In some examples, the optical hardware comprises a fully connected linear optical mesh comprising n waveguides, wherein the waveguides are numbered consecutively from 1 to n, and n is a positive integer of at least 3; and a plurality of couplers, wherein: at a first series of interaction stages in the fully connected linear optical mesh a waveguide numbered $i$ is coupled to a waveguide $i+1$ by a coupler, wherein $i$ is an odd positive integer from 1 to n-1; at a second series of interaction stages in the fully connected linear optical mesh a waveguide numbered $j$ is coupled to a waveguide numbered $j+1$ by a coupler, wherein $j$ is an even positive number from 2 to n-1; and the first series of interaction stages and the second series of interaction stages alternate. This provides a practical optical hardware set up that may be used as a base for implementing unitaries via implementing the universal linear optical mesh.

In some examples, the method further comprises obtaining a characterization of the optical hardware, wherein the characterization of the optical hardware identifies couplers in the optical hardware that underperform relative to other couplers in the optical hardware; identifying one or more revised layouts of the multiple potential revised layouts that do not require use of a coupler at a position in the optical hardware where a coupler underperforms relative to other couplers in the optical hardware; and selecting a selected revised layout from the one or more revised layouts. In general, manufacturing errors means optical hardware is often underperforming with some couplers of the optical hardware having a lower performance than other couplers of the optical hardware. It can therefore be desirable to implement a universal linear optical mesh on the optical hardware while "ignoring" the underperforming optical elements by having them act as zero or throughput elements that do not interact with light in the waveguides and do not couple waveguides. To this end, the multiple potential revised layouts can all be mapped to optical hardware where the underperforming couplers have been identified in a way that minimizes the use of these underperforming couplers when implementing the universal linear optical mesh. When multiple potential revised layouts for a universal linear optical mesh exist, then these can all be mapped to the optical hardware and a layout that minimizes or doesn't use the underperforming couplers of the hardware selected for a practical implementation of the universal linear optical mesh.

In some examples selecting the revised layout from the one or more revised layouts comprises either: selecting the selected revised layout from the one or more revised layouts at random; or selecting the selected revised layout that most closely reflects the Reck triangular mesh layout; or selecting the selected revised layout with the lowest optical depth. When more than one of the multiple potential revised layouts minimize use of the underperforming couplers, then a revised layout from these more than one layouts needs to be chosen for implementation on the optical hardware. The above provides ways to do this.

In some examples, the method further comprises using the optical hardware to implement the revised layout or selected revised layout; and optionally mapping a unitary operation onto the revised layout or selected revised layout; and using the revised layout or selected revised layout to implement the unitary operation on the fully connected linear optical mesh. Thus, the revised layout can be practically implemented on optical hardware and used to implement unitary operations for quantum computing, optical routing, optical switching or any other purpose.

In some examples each coupler comprises a tuneable beam splitter, and optionally, wherein each tuneable beam splitter comprises a Mach-Zehnder interferometer with a phase shifter in one path or both paths of the Mach-Zehnder interferometer. This provides a practical way to implement the couplers.

A second aspect provides a classical computing device comprising: a processor; and a memory, wherein the memory stores instructions that when executed by the processor causes the processor to implement a method accord to any of the above examples.

A third aspect provides a non-transitory computer readable storage medium comprising instructions that when executed by a processor cause the processor to implement a method according to any of the above examples.

The methods described herein may be performed by software in machine readable form on a tangible storage medium e.g. in the form of a computer program comprising computer program code means adapted to perform all the steps of any of the methods described herein when the program is run on a computer and where the computer program may be embodied on a computer readable medium. Examples of tangible (or non-transitory) storage media include disks, thumb drives, memory cards etc and do not include propagated signals. The software can be suitable for execution on a parallel processor or a serial processor such that the method steps may be carried out in any suitable order, or simultaneously.

This acknowledges that firmware and software can be valuable, separately tradable commodities. It is intended to encompass software, which runs on or controls "dumb" or standard hardware, to carry out the desired functions. It is also intended to encompass software which "describes" or defines the configuration of hardware, such as HDL (hardware description language) software, as is used for designing silicon chips, or for configuring universal programmable chips, to carry out desired functions.

The preferred features may be combined as appropriate, as would be apparent to a skilled person, and may be combined with any of the aspects of the invention.

Brief Description of the Drawings

Embodiments of the invention will be described, by way of example, with reference to the following drawings, in which:

Figure 1 shows an example of a known layout for a universal linear optical mesh according to a Reck scheme

Figure 2 is a flow diagram of a method for generating revised layouts for universal linear optical meshes;

Figure 3 shows an arrangement of couplers in Figure 3(1) that can be substituted for an arrangement of couplers in Figure 3(2) in accordance with the disclosure;

Figures 4A to 4J show results of an iterative/repeated method for generating multiple potential revised layouts for a universal linear optical mesh from a known linear optical mesh;

Figures 5A to 5J show results of an alternative iterative/repeated method for generating multiple potential revised layouts for a universal linear optical mesh from a known linear optical mesh;

Figures 6A to 6K show mappings of a known universal linear optical mesh and multiple revised layouts for a universal linear optical mesh to optical hardware comprising underperforming couplers;

Figure 8 shows a potential implementing of a coupler; and

Figure 9 shows a classical computing system that can be used to implement the example methods of this application.

Common reference numerals are used throughout the figures to indicate similar features.

Detailed Description

Embodiments of the present invention are described below by way of example only. These examples represent the best ways of putting the invention into practice that are currently known to the Applicant although they are not the only ways in which this could be achieved. The description sets forth the functions of the example and the sequence of steps for constructing and operating the example. However, the same or equivalent functions and sequences may be accomplished by different examples.

Quantum computing is a developing field of technology wherein the bits of a classical computer are replaced by quantum bits, or qubits, that can be in a superposition of zero and one at the same time. This combined with entanglement has resulted in the development of quantum computing algorithms that have improved time scaling with the size of the input problem compared to best known classical cases. In some instances, such as Shor's factoring algorithm, these improvements can be exponential. In order to implement these algorithms, it would be desirable to build a universal quantum computer. While various different technologies exist to build quantum computers and qubits, one promising technology is optical or photonic quantum computing wherein the qubits are encoded in photons or squeezed states of light. While in optical or photonic quantum computing, specific circuits can be constructed to implement an algorithm, ideally hardware that can be used for any quantum algorithm (e.g. universal hardware) would be used. One option for such hardware is a universal linear optical mesh which can be used as part of a photonic quantum computer to implement any quantum unitary operation as part of a quantum algorithm. A universal linear optical mesh can also be known as a Multi-mode Mach-Zehnder interferometer.

A universal linear optical mesh comprises a plurality of waveguides and a plurality of couplers wherein each coupler couples two waveguides. In use, modes of light will travel through the waveguides from an input port to an output. The modes of light can comprise qubits, squeezed light, laser light, qudits etc. Each coupler can be used to couple the modes of light in the waveguides coupled by the coupler. In this regard it is noted that the couplers are variable or tuneable. Hence, each coupler can be tuned to couple the modes of light in the waveguides coupled by the coupler or can be tuned to allow the modes of light to pass through without coupling.

A linear optical mesh can be considered to be an arrangement of waveguides and couplers wherein each coupler couples a pair of nearest neighbour waveguides at an interaction stage. In use, each waveguide transports/guides/carries light with a mode of light coupling between waveguides via couplers. Each mode of light can be considered to travel from an input port to an output port. The interaction stages can also be referred to as interface stages, interaction points or interface points and can be considered to be a point along a waveguide where a coupler is positioned. In general it would be expected that multiple pairs of waveguides couple via a corresponding coupler at each interaction stage. However, this is by no means essential so in some examples there may be only a single pair of waveguides coupling at one or more or even all of the interaction stages. The layout of a universal linear optical mesh is a layout of waveguides and couplers that enable the universal linear optical mesh to be implemented on optical hardware comprising the waveguides and couplers. In some examples the optical hardware used to implement a universal optical mesh may comprise more waveguides and couplers than needed to implement the universal linear optical mesh and some components of the optical hardware will not be used.

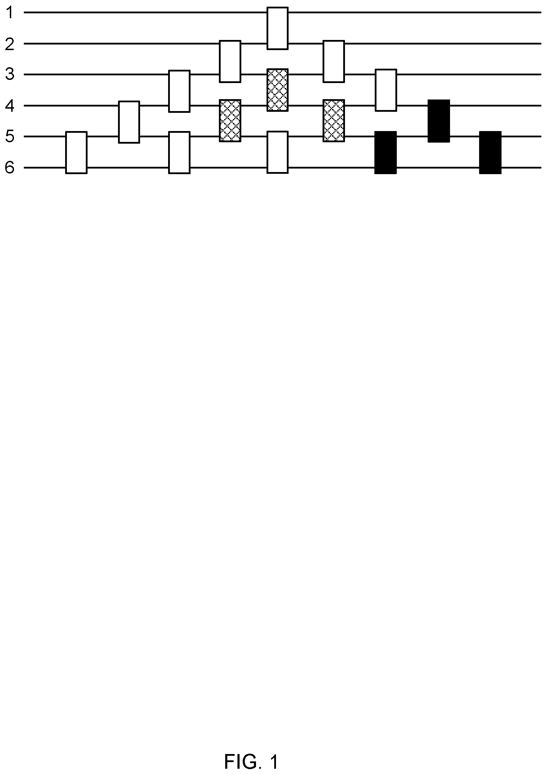

Universal linear optical meshes are universal since any unitary can be mapped to a suitably sized universal linear optical mesh. However, only a couple of designs for such universal linear optical meshes are known. One example is known as a Reck's triangular scheme, which is shown in Figure 1. In this scheme there are n waveguides numbered from 1 to n, wherein n is a positive integer of at least 3. In the Reck scheme, the waveguides interface in a triangular pattern over 2n-3 interaction stages. Here, n waveguides numbered from 1 to n, wherein n is a positive integer, interface in a plurality of interaction stages. In the Reck scheme, the interaction stages are arranged in a linear fashion such that they taper up in the number of interaction stages each path encounters if traced from any input i to corresponding output i. Here, the number of interaction stages along any waveguide path numbered i to corresponding output i is equal to i for all i from 1 to n-1. In the Reck scheme, at the first subset of the interaction stages j where j is an odd number, waveguides numbered i interface with waveguides numbered i-1, wherein i is an integer from the set {n, n-2,...,2}. In a second subset of the interaction stages j, where j even number, waveguides numbered k interface with waveguides numbered k+1 wherein k is an even number from the set {n-1,n-3,...,1}. The first subset and second subset of interaction stages alternate and either the first or second subset of interaction stages can be the first or initial interaction stages.

Another known scheme is the Clements rectangular scheme. Here n waveguides numbered from 1 to n, wherein n is a positive integer, interface in a plurality of interaction stages. In the Clements scheme, at a first subset of the interaction stages waveguides numbered i interface with waveguides numbered i+1 wherein i is an odd number from 1 to n-1 and in a second subset of the interaction stages waveguides numbered j interface with waveguides numbered j+1 wherein j is an even number from 2 to n-1. The first subset and second subset of interaction stages alternate and either the first or second subset of interaction stages can be the first or initial interaction stages in the universal optical mesh.
While schemes for implementing universal linear optical meshes are known, these have disadvantages. For example, in the Reck scheme light in a first waveguide passes through a least number of couplers while light in an nth waveguide passes through a maximum number of couplers causing an unequal loss and phase distribution for light in different waveguides. In addition, the Reck scheme has a relatively large optical path length as the overall path length is 2n. It would be advantageous to be able to find new layouts for a universal linear optical mesh that overcome these disadvantages.

In addition, the above two designs/layouts are mapped to optical hardware to enable their implementation. In some examples, the optical hardware is built to the layout of the linear optical mesh. However, in many practical implementations the optical hardware will pre-exist (such as in the form of a fully connected linear optical mesh or another optical hardware comprising a plurality of waveguides and couplers) and then the universal linear optical mesh will be mapped onto the components that exist in the optical hardware. One or more couplers in the optical hardware may have lower performance than the other couplers in the optical hardware due to manufacturing tolerances. Depending on the position of the one or more couplers in the optical hardware, the existing designs/layouts may require use of these one or more couplers and these one or more coupler may result in significant errors in any unitary implemented. It is thus desirable to identify other potential universal linear optical meshes to enable a suitable universal linear optical mesh to be chosen to take into account manufacturing constraints e.g. lower performance components and/or resource trade offs for particular unitaries.

While the above has concentrated on quantum computing, universal linear optical meshes can be used to implement other optical operations that can be expressed by unitaries. For example, universal linear optical meshes can be used to implement optical routing/switching, linear optical operations, phase matching, splitting light (e.g. using a Fourier transform to split light into n equal modes), machine learning applications and other optical computing operations.

Given the above, a method for generating/obtaining revised layouts for universal linear optical meshes is disclosed. This method allows one or more alternative universal linear optical meshes to be generated/obtained from a known layout for a universal linear optical mesh by a simple substitution of couplers in the known universal linear optical mesh. By repeat substitution, it is possible to obtain multiple universal linear optical meshes and then map these onto the existing optical hardware or build new optical hardware based on these layouts. A suitable universal linear optical mesh can then be chosen based on the bounds and/or limitations of the hardware to enable a general unitary operation to be implemented.

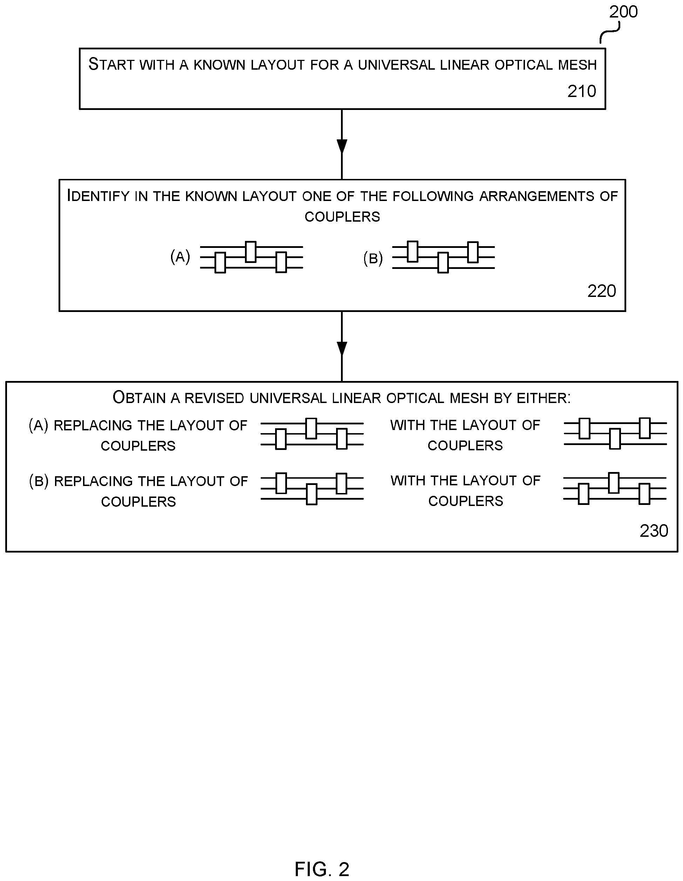

Figure 2 shows a flow chart of a method 200 for generating/determining a revised layout for a universal linear optical mesh from a known layout for a universal linear optical mesh. The generated/obtained revised layout can then be mapped to a fully connected linear optical mesh or other existing optical hardware and used to implement unitaries on the fully connected linear optical mesh or other existing optical hardware.

In step 210, the method comprises starting from or with the known layout for a universal optical mesh. The known layout may comprise one of the known layouts described above. For example, the known layout may comprise the Reck triangular mesh. Alternatively, the known layout may comprise the Clements rectangular mesh. However, in other examples the known layout may comprise any other known layout for a universal linear optical mesh which may have been obtained using the method of Figure 2 itself or in any other way.

In step 220, the method then comprises identifying in the known layout an arrangement of three couplers across three waveguides wherein, as explained in more detail below, the couplers are arranged in a triangular or inverse triangular arrangement. The three couplers can be represented by a 3×3 unitary matrix or 3×3 unitary which can be used to define how the coupler couples the modes of light in the three waveguides. In step 230, the method comprises obtaining the revised layout by replacing the arrangement of three couplers with an alternative arrangement of three couplers. In this regard, if the arrangement of three couplers is a triangular arrangement, then the alternative arrangement is an inverse triangular arrangement. Conversely, if the arrangement of three couplers if an inverse triangular arrangement then the alternative arrangement is a triangular arrangement.

In regards to the above substitutions, the skilled person would understand that in order to map a unitary, $U(\theta, \phi)$, onto a universal linear optical mesh such as a Reck triangular mesh or a Clements rectangular mesh, the unitary needs to be parameterized into a product of unitaries in the group SU(2). This can be done a process known as nullification where elements of the unitary $U(\theta, \phi)$ are nulled in a triangle and the direction of nulling is fixed to right multiplication where column transformations are used (as opposed to left multiplication where row transformations are used). It is known from the document R. Vanderbril et al. "A parallel QR-factorization/solver of quasiseparable matrices" Electronic Transactions on Numerical Analysis, Volume 30, pages 144-167 that for a 3x3 unitary matrix and fixing the direction to right multiplication, there are two ways to do this either starting from the lower left element in the 3x3 unitary matrix or starting from the upper right element of the 3×3 unitary matrix.

If the nulling starts from the lower left element then a lower left triangle of the 3×3 unitary matrix is nullified. This results in a 3×3 unitary matrix being decomposed into three 2×2 unitary matrices as shown in equation 1 wherein:

$$\begin{bmatrix} x & x & x \\ x & x & x \\ x & x & x \end{bmatrix} = \begin{bmatrix} x & x & 0 \\ x & x & 0 \\ 0 & 0 & 1 \end{bmatrix} \begin{bmatrix} 1 & 0 & 0 \\ 0 & x & x \\ 0 & x & x \end{bmatrix} \begin{bmatrix} x & x & 0 \\ x & x & 0 \\ 0 & 0 & 1 \end{bmatrix} \quad (1).$$

Similarly, if the nulling starts from the upper right element then an upper right triangle of the 3×3 unitary matrix is nullified. This results in a 3×3 unitary matrix being decomposed into three 2×2 unitary matrices as shown in equation 2, wherein:

$$\begin{bmatrix} x & x & x \\ x & x & x \\ x & x & x \end{bmatrix} = \begin{bmatrix} 1 & 0 & 0 \\ 0 & x & x \\ 0 & x & x \end{bmatrix} \begin{bmatrix} x & x & 0 \\ x & x & 0 \\ 0 & 0 & 1 \end{bmatrix} \begin{bmatrix} 1 & 0 & 0 \\ 0 & x & x \\ 0 & x & x \end{bmatrix} \quad (2).$$

In equations (1) and (2) above, the entries $x$ represent values in the matrix and the values may differ between elements. The equations (1) and (2) are equivalent up to a global phase.

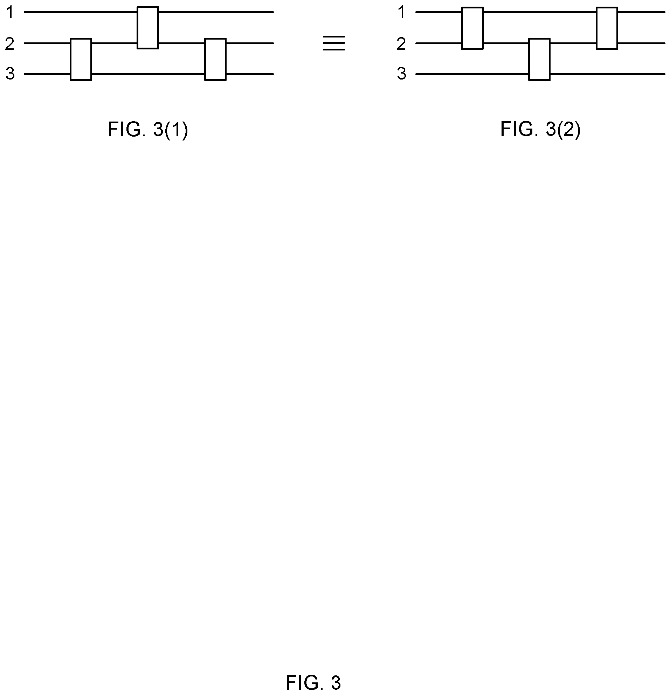

Turning now to Figure 3, in arrangements of waveguides and couplers, equation (1) can be mapped onto the arrangement of three waveguides and couplers shown in Figure 3(1), wherein the couplers are tuned to implement the 2×2 matrices. Here there are three waveguides numbered 1, 2, 3 and in a first interaction stage waveguide 2 is coupled to waveguide 3 via a first coupler, in a second interaction stage waveguide 1 is coupled to waveguide 2 via a second coupler and in a third interaction stage waveguide 2 is coupled to waveguide 3 via a third coupler. Similarly, equation (2) can be mapped onto the arrangement of three waveguides and couplers shown in Figure 3(2). Here there are also three waveguides numbered 1, 2 and 3. However, here, in the first interaction stage waveguide 1 couples to waveguide 2 via a first coupler, in the second interaction stage waveguide 2 couples to waveguide 3 via a second coupler, and in the third interaction stage waveguide 1 couples to waveguide 2 via a third coupler. As equations (1) and (2) are equivalent up to a global phase (which can be ignored since it cannot be measured) so are Figures 3(1) and Figures 3(2). Thus, in any arrangement of a universal linear optical mesh, an arrangement of couplers as shown in Figure 3(1) can be replaced with an arrangement of couplers as shown in Figure 3(2) and vice versa without impacting the universality of the universal linear optical mesh. This allows alternative arrangements for a universal linear optical mesh to be generated/obtained.

In order to be able substitute equation (1) and equation (2) and hence the arrangement in Figure 3(1) and Figure 3(2), in a universal linear optical mesh, the 3×3 unitary being decomposed needs to be independent of any other coupler being implemented in that no other coupler should couple to a mode of light (or waveguide) represented by the unitary within the interaction stages represented by the unitary. Otherwise the replacement will impact the other 3×3 unitary. In regards to identifying when the 3×3 unitary is independent based on an arrangement in a universal linear optical mesh, then this is the case if no other coupler interferes or is formed within the arrangement of the three couplers. In regards to Figure 3(1) this requires that no other coupler couples to waveguides 1, 2 or 3 between the first coupler and third coupler. In regards to Figure 3(2) this requires no other waveguide couples to waveguides 1, 2 or 3 between the first coupler and the third coupler. Examples of coupler arrangements that can and cannot be substituted are shown in Figure 1 where the cross-hatched arrangement cannot be substituted due to a blocking coupler while the fully shaded arrangement can be substituted.

The above description has described a decomposition of a 3×3 unitary and so referred to a first, second and third waveguide. However, the above substitutes can be used as part of a larger system. In this regard, the above substitutions can be considered to apply to three waveguides from a larger system where the waveguides are numbered k, k+1 and k+2.

With the above defined, steps 220 and 230 of Figure 2 can be discussed in more detail. In particular, step 220 the identifying the known layout of three couplers comprises identifying either the arrangement of couplers shown in Figure 3(1) or Figure 3(2) while the step 230 comprises replacing this with the alternative layout shown in Figure 3(2) or Figure 3(1).

In a first example, the arrangement of couplers shown in Figure 3(1) is replaced with the arrangement of couplers shown in Figure 3(2). In this example, the step of identifying in the known layout a first arrangement of three couplers across three waveguides comprises identifying three couplers across three consecutive waveguides, which are numbered k, k+1 and k+2 as described above for convenience (and wherein k is a positive integer). The identified three couplers comprise a first coupler that couples waveguide k+1 and k+2, a second coupler that couples waveguides k and k+1 and a third coupler than couples waveguides k+1 and k+2, wherein the three couplers are positioned in separate interaction stages in numerical order. In some examples the three couplers are positioned in consecutive interaction stages. However, in all examples, there should be no other couplers between the first coupler and the third coupler that also couple waveguides k, k+1 or k+2 to another waveguide. Thus, the first arrangement identified corresponds to the arrangement of waveguides shown in Figure 3(1) and described by equation (1). In this example, the step of obtaining the revised layout by replacing the arrangement of three couplers with an alternative arrangement of three couplers comprises replacing the first arrangement of three couplers with a second arrangement of three couplers comprising a first coupler that couples waveguides k and k+1, a second coupler that couples waveguides k+1 and k+2 and a third waveguide that couples waveguides k and k+1. The three couplers are arranged numerically with each coupler being in a different interaction stage. In some examples, the three couplers can be positioned in consecutive interaction stages. This second arrangement of three couplers is equivalent to the arrangement shown in Figure 3(2) and described be equation (2).

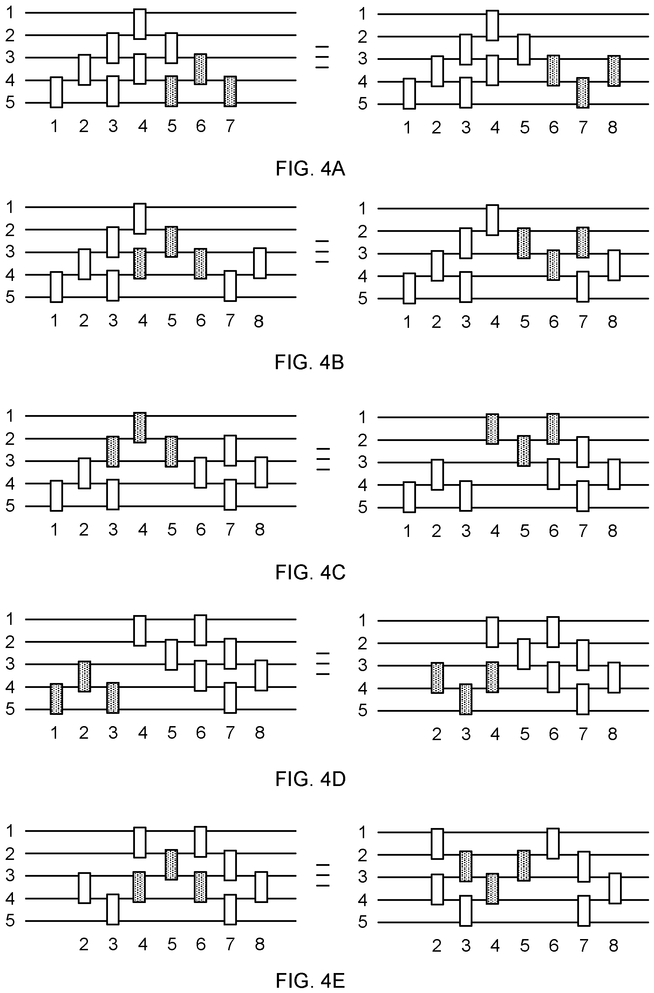

Figure 4A shows an example of the above first example substitution occurring when the known starting layout is a Reck triangular lattice. Here the three couplers on the right are being substituted. However, the skilled person would understand that as an alternative the three couplers on the left could also be substituted. As the three couplers being substituted meet the requirements above and the initial starting layout is a universal linear optical mesh the obtained arrangement is also a universal linear optical mesh. In this case, the obtained universal linear optical mesh is previously unknown. This revised layout provides an alternative way of implementing a universal linear optical mesh which may map in an improved way to optical hardware when the optical hardware has manufacturing errors.

In a second example, the arrangement of couplers shown in Figure 3(2) is replaced with the arrangement of couplers shown in Figure 3(1). In this example, the step of identifying in the known layout a first arrangement of three couplers across three waveguides comprises identifying three couplers across three consecutive waveguides, which are numbered k, k+1 and k+2 as described above for convenience (and wherein k is a positive integer). The identified three couplers comprise a first coupler that couples waveguide k and k+1, a second coupler that couples waveguides k+1 and k+2 and a third waveguide couples waveguides k and k+1, wherein the three couplers are positioned in separate interaction stages in numerical order. In some examples the three couplers are positioned in consecutive interaction stages. However, in all examples, there should be no other couplers between the first coupler and the third coupler that also couple waveguides k, k+1 or k+2 to another waveguide. Thus, the first arrangement identified corresponds to the arrangement of waveguides shown in Figure 3(2) and described by equation (2). In this example, the step of obtaining the revised layout by replacing the arrangement of three couplers with an alternative arrangement of three couplers comprises replacing the first arrangement of three couplers with a second arrangement of three couplers comprising a first coupler that couples waveguides k+1 and k+2, a second coupler that couples waveguides k and k+1 and a third waveguide that couples waveguides k+2 and k+2. The three couplers are arranged numerically with each coupler being in a different interaction stage. In some examples, the three couplers can be positioned in consecutive interaction stages. This second arrangement of three couplers is equivalent to the arrangement shown in Figure 3(1) and described be equation (1).

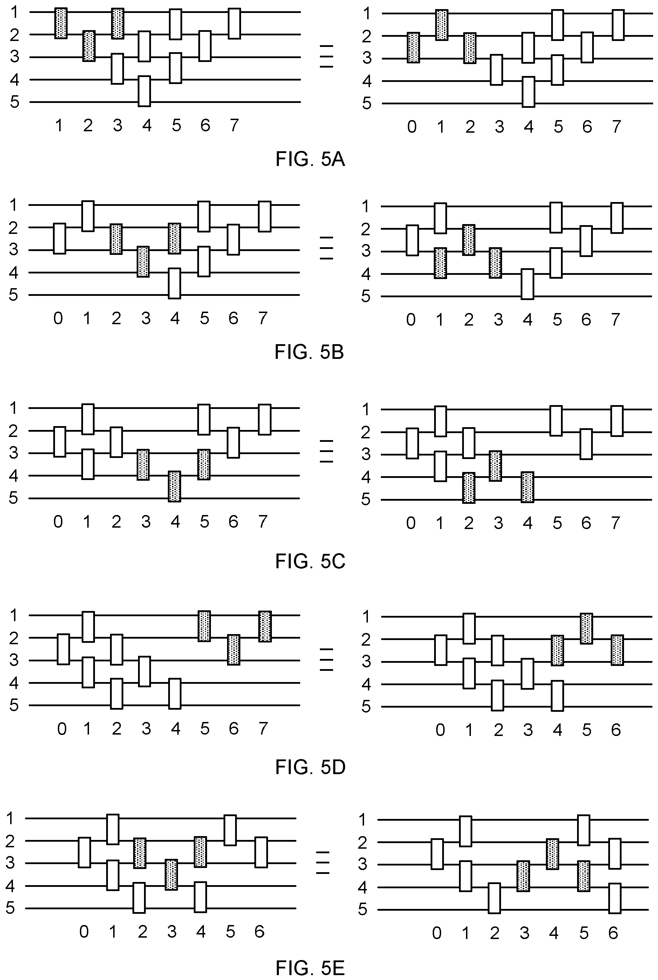

Figure 5A shows an example of the above second example substitution occurring when the known starting layout is an upside down Reck triangular lattice. Here the three couplers on the left are being substituted. However, the skilled person would understand that as an alternative the three couplers on the right could also be substituted. As the three couplers being substituted meet the requirements above and the initial starting layout is a universal linear optical mesh the obtained arrangement is also a universal linear optical mesh. In this case, the obtained universal linear optical mesh is previously unknown. Thus, this layout provides an increased number of options for implementing the universal linear optical mesh on optical hardware.

Given the above, the method 200 from Figure 2 enables an alternative or revised layout for implementing a universal linear optical mesh to be derived from a known layout for a universal linear optical mesh. This allows schemes, arrangements or layouts for implementing universal linear optical meshes to be obtained that allow different forms of hardware to be used to implement universal linear optical meshes.

In some examples, as well as generating/obtaining alternative or revised layouts of universal linear optical meshes, the method comprises using the alternative or revised layout. In order to use the revised layout, the revised layout is mapped to an optical hardware or an optical hardware is formed to match the revised layout. In some examples, the optical hardware may comprise a fully connected interferometer or fully connected optical mesh. Such a fully connected interferometer or fully connected optical mesh may comprise n waveguides numbered from 1 to n wherein n is a positive integer of at least 3. Each waveguide can be considered to have a start and end and a mode of light in a fully connected optical mesh can couple between waveguides via couplers. The fully connected interferometer or fully connected optical mesh can comprise a plurality of couplers arranged in two sets of interaction stages. In a first set of interaction stages, a coupler couples waveguides numbered i to waveguides numbered i+1 wherein i is an odd number from 1 to n-1. In second set of interactions stages, a coupler couples waveguides numbered j to waveguides numbered j+1 wherein j is an even number from 2 to n-1. The first and second set of interaction stages alternate. The initial interaction stage in the fully connected interferometer or fully connected optical mesh is the first or initial set of couplers after the start of the waveguides or the point where the modes of light enter the fully connected interferometer e.g. the most downstream interaction stage. The initial interaction stage can be either part of the first set of interaction stages or the second set of interaction stages. In other examples alterative optical hardware comprising waveguides and couplers is used. In either case, mapping the revised layout to the optical hardware can comprise overlaying the waveguides and couplers of the revised layout with the waveguides and couplers of the optical hardware wherein not all couplers or waveguides of the optical hardware need to be used. Alternatively, an optical circuit or optical hardware may be built specifically based on the revised layout with waveguides and couplers positioned according to the revised layout. Once the revised layout has been mapped to optical hardware or specific optical hardware has been built, the optical hardware can be used to implement quantum operations and unitaries via the revised layout.

Figure 2 has described a method 200 of obtaining/generating a revised layout for implementing a universal linear optical mesh. In some examples, this method can be repeated to obtain/generate multiple revised layouts for implementing a universal linear optical mesh. As discussed in more detail below, these multiple revised layouts can then be analysed to determine a suitable layout for a particular hardware or problem.

In order to obtain or generate multiple revised layouts, the method 200 of Figure 2 is repeated multiple times wherein each time the method is repeated a new potential revised layout is obtained. Each repetition can also be referred to as an iteration. However, the skilled person would understand that each repetition or iteration obtains a revised layout rather than the procedure being repeated or iterated until a single revised layout is obtained.

Given the above, in some examples, the method comprises performing multiple iterations or repetitions of the method in Figure 2. To this end, the first iteration or repetition starts from a known layout for a universal linear optical mesh and the method of Figure 2 is implemented as described above. In each subsequent iteration or repetition, the starting layout is the revised layout obtained in a previous repetition or iteration. The method then comprises repeating the steps of Figure 2 to obtain an additional revised layout. It is noted to avoid "backstepping" each iteration or repetition should perform the same substitution. Thus, if the first iteration or repetition involves replacing a layout of couplers from Figure 3(1) with a layout of couplers from Figure 3(2) then subsequent repetitions should also perform this form of replacement. Similarly if the first iteration or repetition involves replacing a layout of couplers from Figure 3(2) with a layout of a couplers from Figure 3(1) then the subsequent repetitions should also perform this form of replacement.

In a first example the method comprises repeatedly identifying a first arrangement of three couplers (as shown in Figure 3(1)) across three consecutive waveguides numbered k, k+1 and k+2. In each repetition or iteration, the three consecutive waveguides can be different consecutive waveguides e.g. k can be a different value for each iteration or repetition. To that end, instead of k the value kt can be used where t is the number of the repetition or iteration although in the below k is used and taken as potentially different for each iteration. The three couplers are in a first arrangement wherein a first coupler couples waveguides k+1 and k+2, a second coupler couples waveguides k and k+1 and a third coupler couples waveguides k+1 and k+2. The couplers are positioned in different interaction stages in numerical order. In some examples, the three couplers can be positioned in consecutive interaction stages. However, in all examples, no other coupler between the first and third coupler couples waveguides k, k+1, or k+2 to another waveguide. The method then comprises, in each repetition or iteration, replacing the first arrangement of three waveguides with a second arrangement of three waveguides wherein the second arrangement comprises a first coupler that couples waveguides k and k+1, a second coupler that couples waveguides k+1 and k+2 and a third coupler that couples waveguides k and k+1. The three couplers in the second arrangement are also in different interaction stages and arranged in numerical order. Again, in some examples the three couplers may be consecutive couplers. The repetitions/iterations can be performed until either a known layout of a universal linear optical mesh is obtained or no further forms of the first arrangement can be identified in the revised layout.

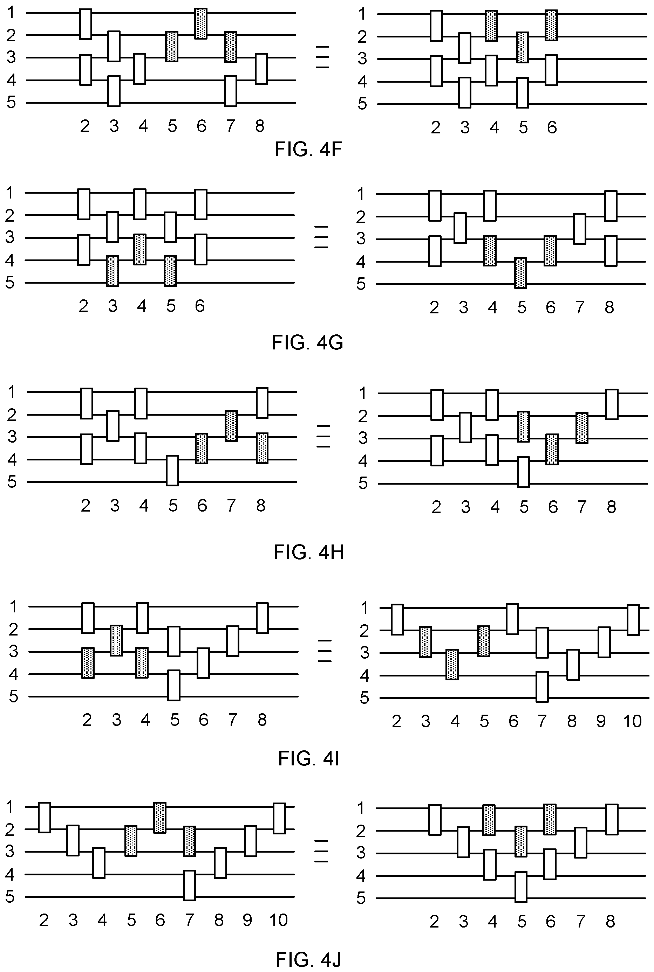

Figure 4A mentioned above, showed a first iteration of method 200 of Figure 2 in relation to the first example described above. Figures 4B, 4C, 4D, 4E, 4F, 4G, 4H, 4I and 4J show further iterations of this method in relation to the first example. The final layout shown in Figure 4J does not contain any additional coupler arrangements of the form from Figure 3(1) thus the method can end. Alternatively, the method can be reperformed starting from the inverse Reck layout and generating an additional plurality of revised layouts by replacing the coupler arrangement from Figure 3(2) with the coupler arrangement from Figure 3(1). This generates another set/group/collection/plurality/multiple of potential revised layouts. While the example in Figures 4A-4J shows the method 200 starting from the right hand side, it would also be possible to generate a plurality of potential revised layouts starting from the left hand side.

In a second example, the first iteration or repetition involves replacing a layout of couplers from Figure 3(2) with a layout of couplers from Figure 3(1) and subsequent repetitions should also perform this form of replacement. To this end, in the second example the method comprises repeatedly identifying a first arrangement of three couplers across three consecutive waveguides numbered k, k+1 and k+2. In each repetition iteration, the three consecutive waveguides can be different consecutive waveguides e.g. k can be a different value for each iteration or repetition. To that end, instead of k the value kt can be used where t is the number of the repetition or iteration. Although once again in the below, the notation k is used and taken to be potentially different for each iteration/repetition. The three couplers are in a first arrangement wherein a first coupler couples waveguides k and k+1, a second coupler couples waveguides k+1 and k+2 and a third coupler couples waveguides k and k+1. The couplers are positioned in different interaction stages in numerical order. In some examples, the three couplers can be positioned in consecutive interaction stages. However, in all examples, no other coupler between the first and third coupler couples waveguides k, k+1 or k+2 to another waveguide. The method then comprises, in each repetition or iteration, replacing the first arrangement of three waveguides with a second arrangement of three waveguides wherein the second arrangement comprises a first coupler that couples waveguides k+1 and k+2, a second coupler that couples waveguides k and k+1 and a third coupler that couples waveguides k+1 and k+2. The three couplers in the second arrangement are also in different interaction stages and arranged in numerical order. Again, in some examples the three couplers may be consecutive couplers. The repetitions/iterations can be performed until either a known layout of a universal linear optical mesh is obtained or no further forms of the first arrangement can be identified in the revised layout.

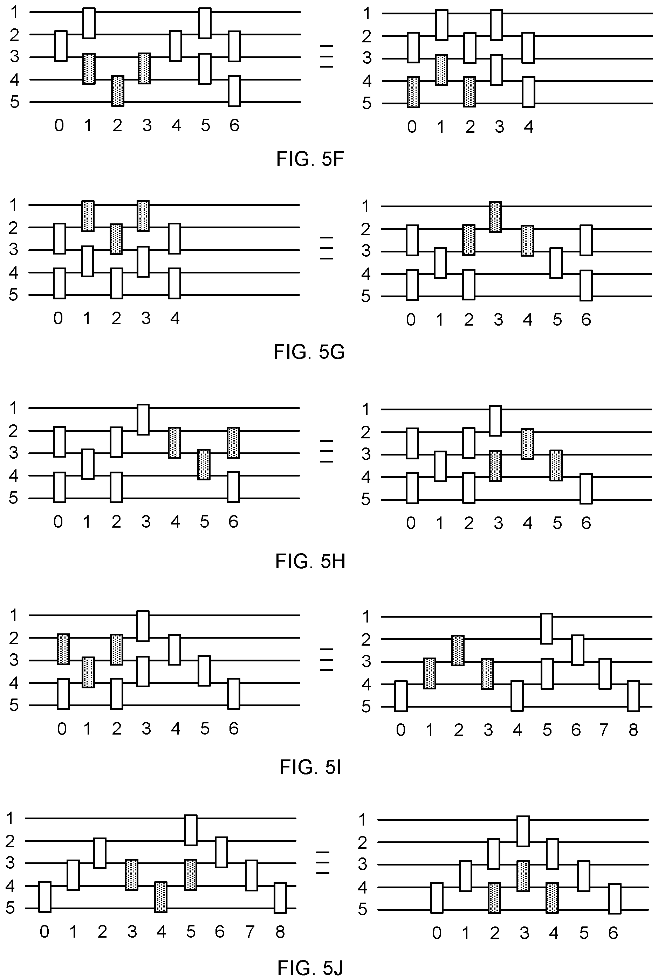

Figure 5A mentioned above, showed a first iteration of method 200 of Figure 2 in relation to the second example described above. Figures 5B, 5C, 5D, 5E, 5F, 5G, 5H, 5I, and 5J show further iterations of this method in relation to the first example. The final layout shown in Figure 5J does not contain any additional coupler arrangements of the form from Figure 3(2). Thus, the method can end as another iteration/repetition cannot be performed. Alternatively, the method can be reperformed starting from the Reck layout and generating an additional plurality of revised layouts by replacing the coupler arrangement from Figure 3(1) with the coupler arrangement from Figure 3(2). This generates another set/group/collection/plurality/multiple of potential revised layouts. While the example in Figures 5A-5J shows the method 200 starting from the left hand side, it would also be possible to generate a plurality of potential revised layouts starting from the right hand side.

When replacing the first arrangement of three couplers with a second arrangement of three couplers the $3 \times 3$ unitary needs to remain independent in that no other coupler in the universal linear optical mesh should interfere couple to a mode (or waveguide) represented by the $3 \times 3$ unitary within the interaction stages represented by the $3 \times 3$ unitary. To this end, the second arrangement of three couplers may shift interaction stages compared to the first arrangement of three couplers. Hence, if at a specific interaction stage, which can be referred to as a first interaction stage or specified interaction stage, in the first arrangement the first coupler of the three couplers couples waveguides k+1 and k+2 and another coupler in the same specific/first interaction stage couples waveguides and k-1 and k, then in the second arrangement, the first coupler of the second arrangement, which couples waveguides k and k+1, is positioned in a subsequent interaction stage to the another coupler. This can be done by having the first coupler be positioned in a subsequent interaction stage to the first interaction stage or having the another coupler be positioned in a preceding interaction stage to the first interaction stage or both. This is to avoid either having two couplers couple to waveguide k in the same interaction stage or to have the another coupler interfere with the second arrangement of couplers. This shifting is shown in Figure 4A where in interaction stage 5 the first coupler of the first arrangement couples waveguides 4 and 5 and the another coupler couples waveguides 2 and 3. In the second arrangement the first coupler of the second arrangement is placed in interaction stage 6 and couples waveguides 3 and 4 while the another coupler remains in interaction stage 5. This prevents the another coupler being positioned within the second arrangement and thus interfering with these couplers.

Similar to the above, if at a specific interaction stage, which can be referred to as a second interaction or another specific interaction stage or a specified interaction stage, a third coupler of the first arrangement, which couples waveguides k and k+1, occurs in the same second interaction stage as another coupler which couples waveguides k+2 and k+3, then in the second arrangement the third coupler of the second arrangement is positioned in an interaction stage preceding the interaction stage containing the another coupler. This can involve the third coupler being placed in an interaction stage preceding the second interaction stage or the another coupler is positioned in an interaction stage after the second interaction stage or both. This ensures the another coupler does not interfere with the second arrangement and ensures the third coupler and another coupler do not try to couple to the same waveguide in a same interaction stage.

While the above has focused on coupler arrangement rules when an arrangement such as that in Figure 3(1) with the arrangement in Figure 3(2) similar rules also apply when replacing the arrangement in Figure 3(2) with Figure 3(1). Here, the specific interaction stage, can be referred to as a first interaction stage or specified interaction stage. If the first coupler of the first arrangement couples waveguides k and k+1 and another coupler couples waveguides k+2 and k+3 in this first interaction stage then the first coupler of the second arrangement is positioned at an interaction stage subsequent to the another coupler e.g. by being placed in an interaction stage subsequent to the first interaction stage or by placing the another coupler in an interaction stage proceeding the first interaction stage. Similarly, if at a specific interaction stage referred to as a second interaction stage or another specified interaction stage, the third coupler of the first arrangement (which couples waveguides k and k+1) is positioned along with another coupler that couples waveguides k+2 and k+3 then in the second arrangement the third coupler and the another coupler are positioned in different interaction stages with the another coupler being positioned in an interaction stage subsequent to the interaction stage containing the third coupler. This can be done either by positioning the another coupler in an interaction stage subsequent to the second interaction stage or positioning the third coupler in an interaction stage preceding the second interaction stage. This can be seen in Figure 5A where in interaction stage 3 a third coupler of a first arrangement couples waveguides 1 and 2 and another waveguide couples waveguides 3 and 4. Once the first arrangement has replaced the second arrangement then the third coupler which couples waveguides 2 and 3 is positioned in the second interaction stage and the another coupler coupling waveguides 3 and 4 remains in interaction stage 3.

The above techniques ensure the 3×3 unitary remains independent and prevents two couplers coupling to the same waveguide in the same interaction stage. It is noted that while the above techniques refer to a first and second interaction stage, these are labels for the interaction stages and any other suitable label could be used. The first interaction stage does not need to be a first interaction stage within the universal linear optical mesh and the second interaction stage does not need to be the second interaction stage within the universal linear optical mesh.

Either when replacing the first arrangement with the second arrangement, or subsequent to replacing the first arrangement with the second arrangement, the layout of the universal linear optical mesh can be compressed. This enables a universal linear optical mesh to be implemented in hardware containing fewer interaction stages which can lead to a more efficient implementation. To this end, if after replacing the first arrangement of three couplers with the second arrangement of three couplers there exists in the layout an arrangement of couplers where a specific coupler couples waveguides I and I+1 in a specific interaction stage and another coupler couples waveguides I+2 and I+3 in another interaction and no other couples to waveguides I, I+1, I+2 or I+3 in any interaction stage between the specific interaction stage and the another interaction stage, then the specific coupler and the another coupler can be rearranged to be in the same interaction stage. Here I is a positive integer. An example of such compressing can be seen in Figure 4D where interaction stage 3 and interaction stage 4 are compressed into the same interaction stage (interaction stage 4) during the replacement of the first arrangement of couplers with the second arrangement of couplers, something which enables the total number of interaction stages to be reduced by one.

As mentioned above, the method for generating/obtaining a revised of a universal linear optical mesh is repeated multiple times with each repetition or iteration of the method producing a potential revised layout. When multiple revised layouts are generated then the above methods of ensuring the 3×3 unitaries remain independent can be performed on the potential revised layout generated from each repetition or iteration. In addition, in some examples, a first set of potential revised layout is generated without compression and a second set of potential revised layouts with compression. Alternatively the compression can be performed for all of the multiple revised layouts while generating the multiple revised layouts.

As discussed above, the layout for the fully connected linear optical mesh can be mapped to optical hardware. The optical hardware can represent a physical layout of waveguides and couplers in a user environment. In some examples, the optical hardware used may comprise a fully connected linear optical mesh The fully connected linear optical mesh comprises n waveguides wherein the waveguides are numbered consecutively from 1 to n, wherein n is a positive integer of at least 3. Each waveguide connects has a start and an end. The fully connected linear optical mesh also comprises a plurality of couplers wherein each coupler couples two waveguides. A mode travelling in the linear optical mesh can couple between waveguides via the couplers. The couplers are distributed over a plurality of interaction stages. The interaction stages have two types. In a first set or series of interaction stages a set/group/plurality of couplers couple a waveguide numbered i to a waveguide numbered i+1 wherein i is an odd positive integer from 1 to n-1. In a second set or series of interaction stages a set/group/plurality of couplers couple a waveguide numbered j to a waveguide numbered j+1 wherein j is an even positive integer from 2 to n-1. The first series of interaction stages and second series of interaction stages alternate and an initial interaction stage e.g. an interaction stage nearest the start of the waveguides or the point where modes of light enter the fully connected optical mesh can be part of the first series of interaction stages or the second series of interaction stages.

In some examples, the mapping of fully connected linear optical mesh to the optical hardware can include performing a mapping based on a characterisation of the optical hardware. To this end, the optical hardware, such as the fully connected linear optical mesh described above can be characterized or otherwise analysed to determine which components of the optical hardware are functioning correctly. In other words, the performance of the couplers in the optical hardware can be accessed and couplers that are underperforming can be identified. The couplers underperforming comprises the couplers having a lower performance than the other couplers in the optical hardware, for example by either over or under coupling modes of light compared to the desired tuning of the coupling or due to loss. This underperformance can be due to the tolerances in the manufacturing procedure, manufacturing errors or for any other reason. For example, as discussed in more detail below, in some examples each coupler can comprise a Mach-Zehnder interferometer formed from two 50/50 beam splitters and a phase shifter in at least one arm of the Mach-Zehnder interferometer. In such examples, a coupler may be underperforming due to loss in the 50/50 beam splitters or an incorrect coupling in the 50/50 beam splitter. In some examples, the characterising of the optical hardware can be done as part of the mapping. In other examples, the characterising is pre-performed offline and stored and is then obtained as part of the mapping. This characterisation can be done in accordance with known methods and can determine couplers with higher loss than other couplers or couplers that do not provide the tuned level of couplings between modes.

Once the characterisation of the optical hardware is obtained then the potential revised layouts can be mapped onto the characterised optical hardware where the mapping aims to not use the couplers that are identified as underperforming. A universal linear optical mesh that can be mapped to the optical hardware without using an underperforming coupler can then be selected as linear optical mesh to be implemented on the hardware. This allows a universal linear optical mesh with a lowest chance of errors to be selected for practical use.

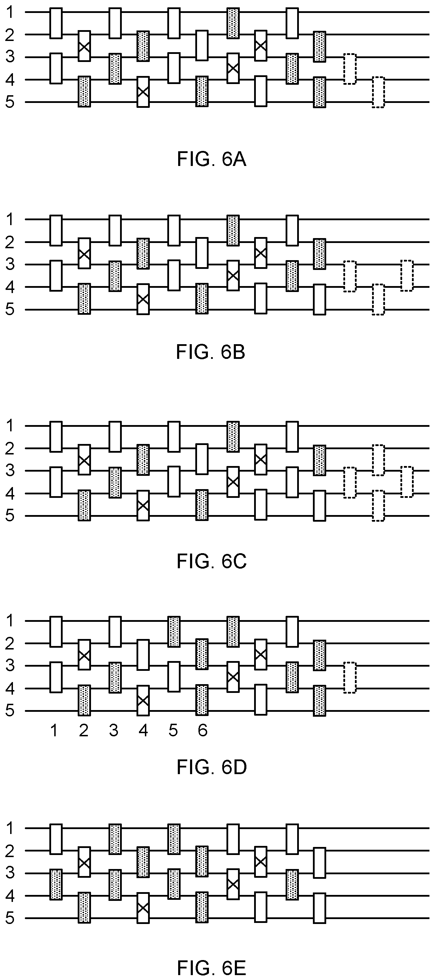

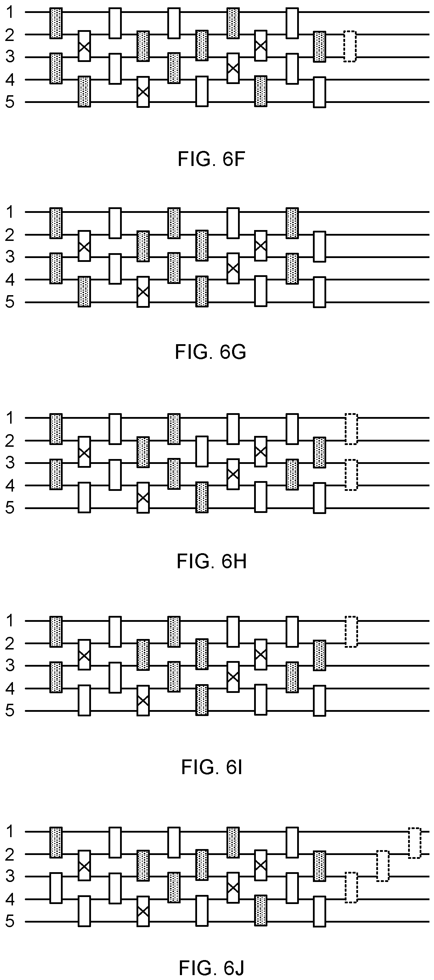

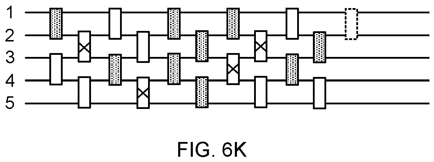

Figures 6A to 6K show an example of this. Figures 6A to 6K show optical hardware comprising a fully connected linear topical mesh wherein the couplers marked with an x are identified from the characterisation as being underperforming. Figure 6A shows an attempt to map a known universal linear optical mesh comprising a Reck triangular scheme to the optical hardware. As can be seen if underperforming couplers are not used then this mapping cannot be fully performed with the remaining couplers from the universal linear optical mesh being shown in dashed lines. Figures 6B to 6K shows mapping to the multiple potential revised layouts from Figures 4A to 4J to the optical hardware. As can be seen, the final potential layouts from Figure 4D (illustrated in Figure 6E) and 4F (illustrated in Figure 6G) map to the optical hardware without using an underperforming coupler. Thus, one of these universal linear optical meshes is selected for use. While performing the mapping, the layout of the linear optical mesh can be further compressed by combining interaction stages if this does not break the independence of the $3{\times}3$ unitaries. An example of this is shown in Figure 6D where the universal linear optical mesh generated in Figure 4C is mapped to the optical hardware. Here the couplers originally in interaction stage 3 are positioned in interaction stage 6 along with the coupler from original interaction stage 5 and after the couplers from interaction stage 4 which in the mapping are in interaction stage 5. This can improve the mapping and aid in finding a mapping that allows the use of couplers identified as underperforming to be not used. In examples where a single potential layout of the universal linear optical mesh can be mapped to the optical hardware, then that layout can be used as the actual implementation of the universal linear optical mesh. Alternatives, a suitable layout can be selected as below.

While Figures 6A to 6K show an example where a mapping can be found, in other examples, it is possible no mapping can be found while avoiding the use of underperforming couplers altogether. In such a scenario, a potential layout of the universal linear optical mesh that minimizes the use of underperforming couplers e.g. by using the fewest underperforming couplers can be selected.

As mentioned above, multiple of the potential layouts of the universal linear optical mesh may be able to be mapped to the optical hardware while avoiding the use of underperforming couplers. In such a case, the selecting the layout to use for implementation of the universal linear optical mesh can comprise selecting the layout from the multiple potential layouts that avoid the use of underperforming couplers. In some examples this selection can be done by at least one of (a) selecting the layout at random; (b) selecting the layout that most closely resembles a Reck triangular mesh; or (c) selecting the about that has the lowest optical depth. The skilled person would understand that any other suitable technique for selecting a layout from multiple layouts that avoid the use of underperforming couplers can be used.

Once a revised layout has been selected for implementation of the universal linear optical mesh (or when only a single layout is generated, the layout that has been generated) the method can further comprise using the revised layout to implement a universal linear optical mesh on the optical hardware. For example, the physical couplers in the optical hardware that map to couplers in the selected layout can be controlled/programmed to implement coupling operations to implement unitary operations on light entering the waveguides. To this end, the method can further comprise mapping a unitary operation onto the selected layout and then implementing the unitary operation using the mapping of the revised layout to the optical hardware.

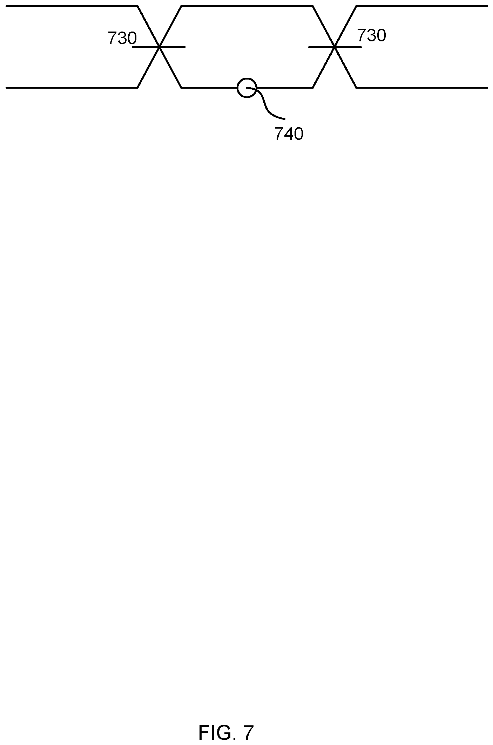

The above has described how waveguides are coupled via couplers. The couplers both in the potential layouts and the physical hardware can comprise tuneable beam splitters, wherein when optical hardware is being considered the tuneable beam splitters are physical tuneable beam splitters. The tuneable beam splitters can take the form of a Mach-Zehnder interferometer with a phase shifter in one or both paths of the Mach-Zehnder interferometer as shown in Figure 7. In particular as shown in Figure 7, the Mach-Zehnder interferometer comprises two 50/50 beam splitters 730 and a phase shifter 740 in one or both of the optical paths generated by the beam splitters 730. This provides a way to implement the couplers.

In some examples, the above methods can be implemented by a computer or computing device. Thus, the above methods can be computer implemented methods. In some examples, the computing device can comprise a classical computing device comprising a processor and a memory storing computer readable instructions that when executed by the processor cause the processor to implement the method. In addition, examples can relate to a non-transitory computer readable storage medium storing instructions that when executed by a processor cause the processor to implement any of the above methods.

Computing-based device 800 comprises one or more processors 802 which may be microprocessors, controllers or any other suitable type of processors for processing computer executable instructions to control the operation of the device in order to implement the above methods. In some examples, for example where a system on a chip architecture is used, the processors 802 may include one or more fixed function blocks (also referred to as accelerators) which implement a part of the method of determining/generating revised layouts for a universal linear optical mesh and mapping it to optical hardware in hardware (rather than software or firmware).

Platform software comprising an operating system 804 or any other suitable platform software may be provided at the computing-based device to enable application software 806 to be executed on the device.

The computer executable instructions may be provided using any computer-readable media that is accessible by computing based device 800. Computer-readable media may include, for example, computer storage media such as memory 808 and communications media. Computer storage media, such as memory 808, includes volatile and non-volatile, removable and non-removable media implemented in any method or technology for storage of information such as computer readable instructions, data structures, program modules or other data. Computer storage media includes, but is not limited to, RAM, ROM, EPROM, EEPROM, flash memory or other memory technology, CD-ROM, digital versatile disks (DVD) or other optical storage, magnetic cassettes, magnetic tape, magnetic disk storage or other magnetic storage devices, or any other non-transmission medium that can be used to store information for access by a computing device. In contrast, communication media may embody computer readable instructions, data structures, program modules, or other data in a modulated data signal, such as a carrier wave, or other transport mechanism. As defined herein, computer storage media does not include communication media. Although the computer storage media (memory 808) is shown within the computing-based device 800 it will be appreciated that the storage may be distributed or located remotely and accessed via a network or other communication link (e.g. using communication interface 810).

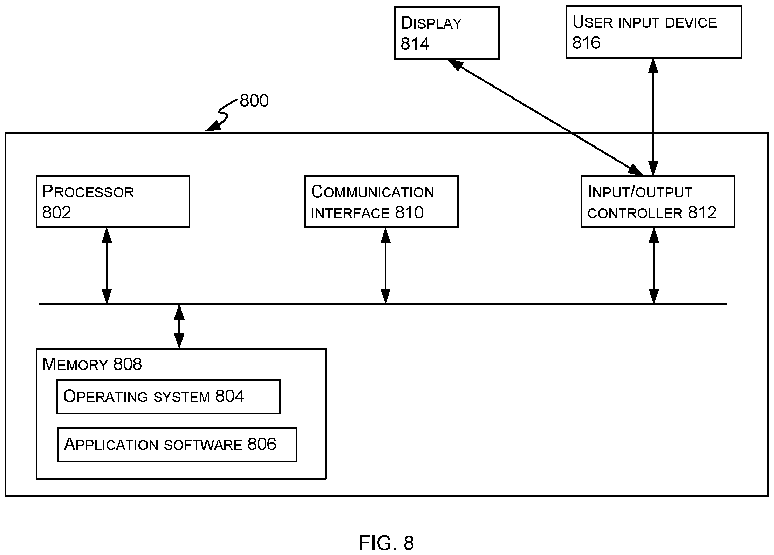

The computing-based device 800 also comprises an input/output controller 812 arranged to output display information to a display device 814 which may be separate from or integral to the computing-based device 800. The display information may provide a graphical user interface. The input/output controller 812 is also arranged to receive and process input from one or more devices, such as a user input device 816 (e.g. a mouse or a keyboard). In an embodiment the display device 814 may also act as the user input device 816 if it is a touch sensitive display device. The input/output controller 812 may also output data to devices other than the display device, e.g. a locally connected printing device (not shown in Figure 8).

The term 'computer' is used herein to refer to any device with processing capability such that it can execute instructions. Those skilled in the art will realize that such processing capabilities are incorporated into many different devices and therefore the term 'computer' includes PCs, servers, mobile telephones, personal digital assistants and many other devices.

Those skilled in the art will realize that storage devices utilized to store program instructions can be distributed across a network. For example, a remote computer may store an example of the process described as software. A local or terminal computer may access the remote computer and download a part or all of the software to run the program. Alternatively, the local computer may download pieces of the software as needed, or execute some software instructions at the local terminal and some at the remote computer (or computer network). Those skilled in the art will also realize that by utilizing conventional techniques known to those skilled in the art that all, or a portion of the software instructions may be carried out by a dedicated circuit, such as a DSP, programmable logic array, or the like.

Any range or device value given herein may be extended or altered without losing the effect sought, as will be apparent to the skilled person.

It will be understood that the benefits and advantages described above may relate to one embodiment or may relate to several embodiments. The embodiments are not limited to those that solve any or all of the stated problems or those that have any or all of the stated benefits and advantages.

Any reference to 'an' item refers to one or more of those items. The term 'comprising' is used herein to mean including the method blocks or elements identified, but that such blocks or elements do not comprise an exclusive list and a method or apparatus may contain additional blocks or elements.

The steps of the methods described herein may be carried out in any suitable order, or simultaneously where appropriate. Additionally, individual blocks may be deleted from any of the methods without departing from the spirit and scope of the subject matter described herein. Aspects of any of the examples described above may be combined with aspects of any of the other examples described to form further examples without losing the effect sought.

It will be understood that the above description of a preferred embodiment is given by way of example only and that various modifications may be made by those skilled in the art. Although various embodiments have been described above with a certain degree of particularity, or with reference to one or more individual embodiments, those skilled in the art could make numerous alterations to the disclosed embodiments without departing from the scope of this invention.

**Claims**

1. A method of generating a revised layout for implementing a universal linear optical mesh, the method comprising:

    starting with a known layout of a universal optical mesh, wherein:

        the known layout of the universal linear optical mesh comprises an arrangement of:

            a plurality of waveguides; and

            a plurality of couplers distributed over a plurality of interaction stages,

        wherein each coupler couples two of the waveguides; and

    and the method further comprises either:

    generating the revised layout by:

        identifying in the known layout a first arrangement of three couplers across three consecutive waveguides numbered k, k+1 and k+2, wherein a first coupler and a third coupler of the three couplers couple waveguides k+1 and k+2, and a second coupler of the three couplers couples waveguides k and k+1, wherein the second coupler is positioned between the first coupler and the third coupler, and wherein no other couplers positioned between the first coupler and the third coupler couple waveguides k, k+1, or k+2 to another waveguide; and
obtaining the revised layout by replacing the first arrangement of three couplers with a second arrangement of three couplers, wherein the second arrangement of three couplers comprises a first coupler and a third coupler that couple waveguides k and k+1 and a second coupler, positioned between the first coupler and the second coupler, that couples waveguides k+1 and k+2; or generating the revised layout by:

        identifying in the known layout a first arrangement of three couplers across three consecutive waveguides numbered k, k+1 and k+2, wherein a first coupler and third coupler of the three couplers couple waveguides k and k+1 and a second coupler of the three couplers couples waveguides k+1 and k+2, wherein the second coupler is positioned between the first and third coupler, and wherein no other couplers positioned between the first coupler and the third coupler couple waveguides k, k+1 or k+2 to another waveguide; and
obtaining the revised layout by replacing the first arrangement of three couplers with a second arrangement of three couplers, wherein the second arrangement of three couplers comprises a first coupler and a third coupler that couple waveguides k+1 and k+2 and a second coupler, positioned between the first coupler and the second coupler, that couples waveguides k and k+1.

2. The method of claim 1, further comprising either:

building optical hardware based on the revised layout; or
mapping the revised layout onto existing optical hardware.

3. The method of claim 1 or claim 2, wherein the known layout of the universal optical mesh is a Reck triangular mesh.

4. The method of any previous claim, wherein: replacing the first arrangement of three couplers with a second arrangement of three couplers, wherein the second arrangement of three couplers comprises a first coupler and a third coupler that couple waveguides k+1 and k+2 and a second coupler, positioned between the first coupler and the second coupler, that couples waveguides k and k+1 comprises:

if at a specific interaction stage containing the first coupler of the first arrangement another coupler couples waveguides k-1 and k, then in the second arrangement positioning the first coupler in an interaction stage subsequent to an interaction stage containing the another coupler; and
if at a specific interaction stage containing the third coupler of the first arrangement another coupler couples waveguides k-1 and k, then in the second arrangement positioning the third coupler in an interaction stage preceding an interaction stage containing the another coupler.

5. The method of any previous claim, wherein: replacing the first arrangement of three couplers with a second arrangement of three couplers, wherein the second arrangement of three couplers comprises a first coupler and a third coupler that couple waveguides k and k+1 and a second coupler, positioned between the first coupler and the second coupler, that couples waveguides k+1 and k+2 comprises:

if at a specific interaction stage containing the first coupler of the first arrangement another coupler couples waveguides k+2 and k+3, then in the second arrangement positioning the first coupler in an interaction stage subsequent to the interaction stage containing the another coupler; and
if at a specific interaction stage containing the third coupler of the first arrangement another coupler couples waveguides k+2 and k+3, then in the second arrangement positioning the third coupler in an interaction stage preceding the interaction stage containing the another coupler.

6. The method of any previous claim, further comprising:
compressing the revised layout by if after the replacing the first arrangement of three couplers with the second arrangement of three couplers (a) a specific coupler couples waveguides I and I+1 and another coupler couples waveguides I+2 and I+3 at different interaction stages and (b) no other coupler couples to waveguides I, I+1, I+2 or I+3 at an interaction stage between the different interaction stages, then further revising the revised layout so that the specific coupler and the another coupler are within the same interaction stage.

7. The method of any previous claim, further comprising generating multiple potential revised layouts for implementing a universal linear optical mesh by:

either generating the multiple potential revised layouts by iteratively:

starting from a previous revised layout;
identifying in the previous revised layout a first arrangement of three couplers across three consecutive waveguides numbered k, k+1 and k+2, wherein a first coupler and a third coupler of the three couplers couple waveguides k+1 and k+2, and a second coupler of the three couplers couples waveguides k and k+1, wherein the second coupler is positioned between the first coupler and the third coupler, and wherein no other couplers positioned between the first coupler and the third coupler couple waveguides k, k+1, k+2 to another waveguide; and
obtaining an updated revised layout by replacing the first arrangement of three couplers with a second arrangement of three couplers, wherein the second arrangement of three couplers comprises a first coupler and a third coupler that couple waveguides k and k+1 and a second coupler, positioned between the first coupler and the second coupler, that couples waveguides k+1 and k+2;

or generating the multiple potential revised layouts by iteratively:

starting from a previous revised layout;
identifying in the previous revised layout a first arrangement of three couplers across three consecutive waveguides numbered k, k+1 and k+2, wherein a first coupler and third coupler of the three couplers couple waveguides k and k+1 and a second coupler of the three couplers couples waveguides k+1 and k+2, wherein the second coupler is positioned between the first and third coupler, and wherein no other couplers positioned between the first coupler and the third coupler couple waveguides k, k+1 or k+2 to another waveguide; and
obtaining an updated revised layout by replacing the first arrangement of three couplers with a second arrangement of three couplers, wherein the second arrangement of three couplers comprises a first coupler and a third coupler that couple waveguides k+1 and k+2 and a second coupler, positioned between the first coupler and the second coupler, that couples waveguides k and k+1.

8. The method of claim 7, further comprising:

mapping each of the multiple potential revised layouts onto an optical hardware comprising a plurality of waveguides and a plurality of couplers, wherein each coupler of the plurality of couplers couples two waveguides from the plurality of waveguides.

9. The method of claim 8, wherein the optical hardware comprises a fully connected linear optical mesh comprising

n waveguides, wherein the waveguides are numbered consecutively from 1 to n, and n is a positive integer of at least 3; and
a plurality of couplers, wherein:

at a first series of interaction stages in the fully connected linear optical mesh a waveguide numbered i is coupled to a waveguide i+1 by a coupler, wherein i is an odd positive integer from 1 to n-1;
at a second series of interaction stages in the fully connected linear optical mesh a waveguide numbered j is coupled to a waveguide numbered j+1 by a coupler, wherein j is an even positive number from 2 to n-1; and
the first series of interaction stages and the second series of interaction stages alternate.

10. The method of claim 8 or claim 9 further comprising:

obtaining a characterization of the optical hardware, wherein the characterization of the optical hardware identifies couplers in the optical hardware that underperform relative to other couplers in the optical hardware;
identifying one or more revised layouts of the multiple potential revised layouts that do not require use of a coupler at a position in the optical hardware where a coupler underperforms relative to other couplers in the optical hardware; and
selecting a selected revised layout from the one or more revised layouts.

11. The method of claim 10, wherein selecting the revised layout from the one or more revised layouts comprises either:

selecting the selected revised layout from the one or more revised layouts at random; or
selecting the selected revised layout that most closely reflects the Reck triangular mesh layout; or
selecting the selected revised layout with the lowest optical depth.

12. The method of claims 2, 10 or 11 further comprising:

using the optical hardware to implement the revised layout or selected revised layout; and optionally
mapping a unitary operation onto the revised layout or selected revised layout; and
using the revised layout or selected revised layout to implement the unitary operation on the fully connected linear optical mesh.

13. The method of any previous claim wherein each coupler comprises a tuneable beam splitter, and optionally, wherein each tuneable beam splitter comprises a Mach-Zehnder interferometer with a phase shifter in one path or both paths of the Mach-Zehnder interferometer.

14. A classical computing device comprising:

a processor; and
a memory, wherein the memory stores instructions that when executed by the processor causes the processor to implement a method accord to any of claims 1 to 13.

15. A non-transitory computer readable storage medium comprising instructions that when executed by a processor cause the processor to implement a method according to any of claims 1 to 13.

FIG. 1

START WITH A KNOWN LAYOUT FOR A UNIVERSAL LINEAR OPTICAL MESH

210

IDENTIFY IN THE KNOWN LAYOUT ONE OF THE FOLLOWING ARRANGEMENTS OF COUPLERS

(A)   (B)

220

OBTAIN A REVISED UNIVERSAL LINEAR OPTICAL MESH BY EITHER:

(A) REPLACING THE LAYOUT OF COUPLERS   WITH THE LAYOUT OF COUPLERS

(B) REPLACING THE LAYOUT OF COUPLERS   WITH THE LAYOUT OF COUPLERS

230

FIG. 2

FIG. 3(1)　　　　　　　FIG. 3(2)

FIG. 3

FIG. 4A

FIG. 4B

FIG. 4C

FIG. 4D

FIG. 4E

FIG. 4F

FIG. 4G

FIG. 4H

FIG. 4I

FIG. 4J

FIG. 5A

FIG. 5B

FIG. 5C

FIG. 5D

FIG. 5E

FIG. 5F

FIG. 5G

FIG. 5H

FIG. 5I

FIG. 5J

FIG. 6A

FIG. 6B

FIG. 6C

FIG. 6D

FIG. 6E

FIG. 6F

FIG. 6G

FIG. 6H

FIG. 6I

FIG. 6J

FIG. 6K

FIG. 7

FIG. 8

800

USER INPUT DEVICE 816

DISPLAY 814

INPUT/OUTPUT CONTROLLER 812

COMMUNICATION INTERFACE 810

PROCESSOR 802

MEMORY 808

OPERATING SYSTEM 804

APPLICATION SOFTWARE 806

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | BELL B A ET AL: "Further compactifying linear optical unitaries", APL PHOTONICS, AMERICAN INSTITUTE OF PHYSICS, 2 HUNTINGTON QUADRANGLE, MELVILLE, NY 11747, vol. 6, no. 7, 13 July 2021 (2021-07-13), XP012258101, DOI: 10.1063/5.0053421 [retrieved on 2021-07-13] * abstract * * figures 1-5 * * page 5, sections V, VI * * page 6, first paragraph * * the whole document * | 1-15 | INV. G06F30/392 G02B6/12 G06F30/398 G02F3/00 G06E1/00 G06E3/00 |
| X | SUNIL PAI ET AL: "Matrix optimization on universal unitary photonic devices", ARXIV.ORG, CORNELL UNIVERSITY LIBRARY, 201 OLIN LIBRARY CORNELL UNIVERSITY ITHACA, NY 14853, 2 August 2018 (2018-08-02), XP081364719, DOI: 10.1103/PHYSREVAPPLIED.11.064044 * abstract * * figures 1, 4 * * sections I, II.A, IV.A-B * * the whole document * | 1-15 | TECHNICAL FIELDS SEARCHED (IPC) G06F G02B G06N G02F G06E |
| A | US 2021/096384 A1 (BRADLER KAMIL [CA] ET AL) 1 April 2021 (2021-04-01) * abstract * * figures 1, 2A, 2B, 8 * * paragraphs [0001], [0006], [0020] – [0023], [0029] – [0042] * * claim 1 * * the whole document * | 1-15 | |

-/--

The present search report has been drawn up for all claims

| Place of search | Date of completion of the search | Examiner |
|---|---|---|
| Munich | 19 February 2025 | Joris, Pierre |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

page 1 of 2

Europäisches
Patentamt

European
Patent Office

Office européen
des brevets

# EUROPEAN SEARCH REPORT

**Application Number**

EP 24 19 7093

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2022/269972 A1 (BANDYOPADHYAY SAUMIL [US] ET AL) 25 August 2022 (2022-08-25)<br>* abstract *<br>* claim 1 *<br>* figures 1A, 1B, 3 *<br>* paragraphs [0007] - [0008] *<br>* the whole document *<br>----- | 1-15 | |

**TECHNICAL FIELDS SEARCHED (IPC)**

The present search report has been drawn up for all claims

| Place of search | Date of completion of the search | Examiner |
|---|---|---|
| Munich | 19 February 2025 | Joris, Pierre |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 19 7093

This annex lists the patent family members relating to the patent documents cited in the above-mentioned European search report.
The members are as contained in the European Patent Office EDP file on
The European Patent Office is in no way liable for these particulars which are merely given for the purpose of information.

19-02-2025

| Patent document cited in search report | Publication date | Patent family member(s) | Publication date |
|---|---|---|---|
| US 2021096384 A1 | 01-04-2021 | CA 3094543 A1<br>US 2021096384 A1 | 26-03-2021<br>01-04-2021 |
| US 2022269972 A1 | 25-08-2022 | NONE | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **R. VANDERBRIL et al.** A parallel QR-factorization/-solver of quasiseparable matrices. *Electronic Transactions on Numerical Analysis*, vol. 30, 144-167